(19) Europäisches Patentamt
European Patent Office
Office européen des brevets

(11) **EP 3 640 303 A1**

(12) **EUROPEAN PATENT APPLICATION**

(43) Date of publication:
**22.04.2020 Bulletin 2020/17**

(21) Application number: **18200798.9**

(22) Date of filing: **16.10.2018**

(51) Int Cl.:
*C09D 1/00* *(2006.01)*  *C03C 17/00* *(2006.01)*
*C09D 5/00* *(2006.01)*  *C09D 5/16* *(2006.01)*
*G02B 1/10* *(2015.01)*  *G02B 1/11* *(2015.01)*
*G02B 1/111* *(2015.01)*  *H01L 31/0216* *(2014.01)*
*C09D 7/40* *(2018.01)*

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **DSM IP Assets B.V.**
**6411 TE  Heerlen (NL)**

(72) Inventor: **REARDON, Damien**
**6100 AA ECHT (NL)**

(74) Representative: **DSM Intellectual Property**
**P.O. Box 4**
**6100 AA Echt (NL)**

(54) **COATING AND COATING FORMULATION**

(57)    A coated substrate comprising a coating layer comprising inorganic oxide and pores, the coating layer demonstrates improved anti-soiling properties. The coated substrate may for example be used in solar modules. Further a coating formulation and use of the coating formulation are disclosed.

**Description**

TECHNICAL FIELD OF THE INVENTION

The invention relates to an anti-reflective coating. More particularly, the invention relates to an anti-reflective coating showing anti-soiling properties as well as a coated substrate, a coating formulation and a solar module, as well as a method of improving anti-soiling properties of a coating.

A coated substrate comprising a coating layer, said layer comprising inorganic oxide and pores is disclosed herein, the coating layer demonstrates improved anti-soiling properties. The coated substrate may for example be used in solar modules. Further a coating formulation and use of the coating formulation are disclosed.

BACKGROUND OF THE INVENTION

Anti-reflective (AR) coatings are coatings deposited on substrates, which require high transmission of light such as cover glasses for solar modules and green house glass, and said coatings can reduce the reflectivity of said substrates. Performance of solar modules tend to decrease over time amongst other reasons also due to soiling of the surface where light is transmitted through. In areas with high soiling rates, it was found that build-up of sand and dust particles provides a substantial contribution to the decreased performance.

OBJECTS OF THE INVENTION

It is the object of the invention to provide an improved coating.

In another aspect of the invention, it is an object of the invention to provide an improved coating formulation.

In a further aspect of the invention, it is an object of the invention to provide a method of improving anti-soiling properties of a coating.

The improvement may for example be achieving of improved anti-soiling properties of the coating, or another feature of the invention.

DISCLOSURE OF THE INVENTION

In an aspect of the invention, the object is achieved by a coating formulation according to the claims, embodiments and aspects as described herein.

In an aspect of the invention, the object is achieved by a coating formulation as described herein.

In further aspects of the invention, the objective is achieved by a method, a coated substrate, or a use according to the claims, embodiments and aspects as described herein,

BRIEF DESCRIPTION OF THE DRAWINGS

The invention is explained below with reference to exemplary embodiments as well as the drawings, in which

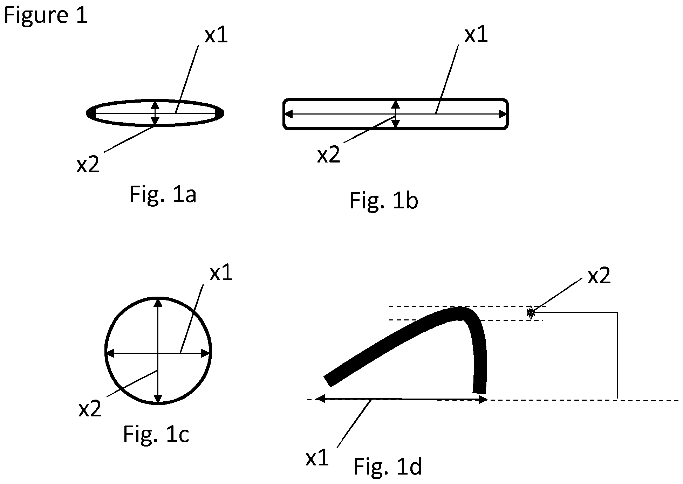

Figure 1a schematically depicts an embodiment of an elongated particle used in the invention with an ellipsoidal shape (2D image of an prolate (elongated) spheroid), having a longer (which may also be referred to as major) axis having a length x1 perpendicular; a shorter (which may also be referred to as minor) axis perpendicular to the longer axis having a length x2; and an aspect ratio (x1/x2) of at least two.

Figure 1b schematically depicts an embodiment of an elongated particle used in the invention with a rod-like shape, having
a longer axis a having length x1; a shorter axis (smaller diameter) perpendicular to the longer axis having a length x2; and an aspect ratio (x1/x2) of at least two.

Figure 1c schematically depicts a spherical particle, having a first axis having a length x1;
a second axis perpendicular to the first axis having a length x2; and an aspect ratio (x1/x2) of about 1.

Figure 1d schematically depicts an embodiment of an elongated particle used in the invention having an irregular shape, having
a longer axis having a length x1; a shorter axis (smaller diameter, shortest dimension of the particle) perpendicular to the longer axis having a length x2 (the length of the longest straight line from one side of the particle to the other side of the particle); and an aspect ratio (x1/x2) of at least two.

DETAILED DESCRIPTION

The invention relates to an improved coating.

Such improved coating may be obtained by converting a coating formulation into a functional coating for example by heating.

Typically, by converting the coating formulation on a substrate into a coated substrate.

Coated substrates, such as a cover glass of a solar module comprising an anti-reflective coating, usually need cleaning at some point in time. In arid areas of the world, cleaning involves among others time and costs and creates waste cleaning materials. There is therefore a need to reduce the cleaning frequency of coated substrates. This invention addresses the reduction of cleaning via improved anti-soiling properties of the coated substrate. The invention provides a coated substrate demonstrating improved anti-soiling properties. The invention provides a coating formulation demonstrating improved anti-soiling properties after application of such formulation on a substrate and converting the dried coating formulation into a coated substrate. The invention provides a solar module demonstrating improved anti-soiling properties.

Improved anti-soiling properties may be demonstrated via reduced frequency of cleaning whilst having the same power output over a time period e.g. 3 months. Improved anti-soiling properties may be demonstrated via an improved power output at the same frequency of cleaning over a time period e.g. 3 months.

Anti-soiling properties may be determined via measuring the transmittance of the anti-reflective coating on a transparent substrate by means of a transmission measurement using a spectrophotometer. The spectrophotometer can be any spectrophotometer which is suitable to analyse a coated substrate. A suitable spectrophotometer includes a Shimadzu UV2600 spectrophotometer. Another suitable spectrophotometer includes an Optosol Transpec VIS-NIR spectrophotometer.

The improved anti-soiling properties may be demonstrated by an increased Anti-Soiling Ratio (ASR) as defined herein. Improved anti-soiling properties may be demonstrated by an increased substrate-coating anti-soiling ratio, ASR, as compared to a reference coated substrate. In an aspect improved anti-soiling properties may be demonstrated by a substrate-coating anti-soiling ratio, ASR, of at least 50%. In an aspect the ASR is at least 55%. In an aspect the ASR is at least 60%. In an aspect the ASR is at least 65%. In an aspect the ASR is at least 70%. In an aspect the ASR is at least 75%. In an aspect the ASR is at least 80%. In an aspect at least 85%. In an aspect the ASR is at least 90%.

In an aspect improved anti-soiling properties may be demonstrated by an increased substrate-coating anti-reflective effect, ARE, as defined herein.

Improved anti-soiling properties may be demonstrated by an increased ARE, as compared to a reference uncoated substrate. In an aspect the ARE is at least 2%, in an aspect the ARE is at least 3%, in an aspect the ARE is at least 4%, in an aspect the ARE is at least 5%.

In an aspect improved anti-soiling properties may be demonstrated by an increased Anti-soiling gain, ASG, as defined herein. Improved anti-soiling properties may be demonstrated by an increased ASG, as compared to a reference uncoated substrate. In an aspect the ASG is at least 50%, in an aspect the ASG is at least 75%, in an aspect the ASG is at least 80%.

The coating formulation according to the invention provides improved anti-soiling properties.

The coating formulation according to the invention provides improved anti-soiling properties to a coating obtained from such formulation after curing i.e. by converting the coating formulation on a substrate into a coated substrate for example by heating, such as by heating above 400 degrees Celsius.

The method according to the invention provides a coated substrate demonstrating improved anti-soiling properties.

The present invention relates to a coating formulation comprising

    i. at least 2 wt-% based on inorganic oxide equivalents of elongated dense inorganic oxide particles with an aspect ratio of at least 2 and a smaller diameter in the range of 3 to 20 nm, and
    ii. a porogen capable of forming pores with a diameter in the range of 10 to 120 nm,
    iii. an inorganic oxide binder, and
    iv. a solvent,

wherein the coating formulation optionally comprises between 0.1 to 30 wt-% aluminium oxide equivalents of aluminium containing compound. In an aspect the coating formulation comprises between 0.1 to 30 wt-% aluminium oxide equivalents of aluminium containing compound. In an aspect the coating formulation comprises between 0.5 to 30 wt-% aluminium oxide equivalents of aluminium containing compound.

The average smaller diameter as referred to herein may be measured from at least one TEM image.

The aspect ratio as referred to herein may be determined from at least one TEM image.

The amount of aluminium oxide equivalents of aluminium containing compound in the ash rest of the coating formulation as referred to herein may be determined via ICP- MS.

In an aspect of the invention, the object is achieved by a coating formulation comprising:

   i. at least 2 wt-% based on oxide equivalents of inorganics of elongated inorganic dense oxide particles with an aspect ratio of at least 2 and an average smaller diameter in the range of 3 to 20 nm as measured by TEM, and
   ii. a porogen capable of forming pores with a diameter in the range of 10 to 120 nm,
   iii. an inorganic oxide binder, and
   iv. a solvent,

wherein the coating formulation comprises between 0.5 to 30 wt-% aluminium oxide equivalents of aluminium containing compound based on total ash rest after combustion at 600°C, 2 min in air, preferably the coating formulation comprises between 1.0 to 25 wt-% aluminium oxide equivalents of aluminium containing compound based on total ash rest after combustion at 600°C.

In an aspect of the invention the coating formulation comprises at least 2 wt-%, at least 3 wt%, at least 4wt%, at least 5wt%, at least 6 wt%, at least 7 wt%, at least 8 wt%, at least 9 wt%, at least 10 wt%, at least 11 wt%, at least 12 wt%, at least 13 wt%, at least 14wt %, at least 15 wt% or at least 16 wt % based on inorganic oxide equivalents of elongated dense inorganic oxide particles with an aspect ratio of at least 2 and a smaller diameter in the range of 3 to 20 nm.

In an aspect of the invention the coating formulation comprises at least 17 wt-%, at least 18 wt%, at least 19 wt%, at least 20 wt%, at least 22 wt%, at least 25 wt% based on inorganic oxide equivalents of elongated dense inorganic oxide particles with an aspect ratio of at least 2 and a smaller diameter in the range of 3 to 20 nm.

The wt% of elongated dense inorganic oxide particles with an aspect ratio of at least 2 and an average smaller diameter in the range of 3 to 20 nm based on inorganic oxide equivalents (wt% elongated particles) may be calculated as follows. The wt % elongated particles = the wt% inorganic oxide equivalents originating from elongated particles as compared to the total amount of silicon oxide equivalents in the coating formulation= $m(SiO_2$ elongated particles)/$m(SiO_2$total)*100=wt% elongated particles = wt% of elongated dense inorganic oxide particles with an aspect ratio of at least 2 and an average smaller diameter in the range of 3 to 20 nm based on inorganic oxide equivalents. With m is gram of solids of elongated particles

In an aspect of the invention the coating formulation comprises at most 30 wt%, at most 28 wt %, at most 26 wt%, at most 25 wt%, at most 22 wt%, at most 20 wt%, at most 18 wt% at most 15 wt% based on inorganic oxide equivalents of elongated dense inorganic oxide particles with an aspect ratio of at least 2 and a smaller diameter in the range of 3 to 20 nm. In an aspect of the invention the coating formulation comprises between 0.1 to 30 wt-% aluminium oxide equivalents of aluminium containing compound. In an aspect of the invention the coating formulation comprises between 0.5 to 30 wt-% aluminium oxide-equivalents of aluminium containing compound. In an aspect of the invention the coating formulation comprises between 0.5 to 25 wt-% aluminium oxide equivalents of aluminium containing compound. In an aspect of the invention the coating formulation comprises between 1.0 to 25 wt-% aluminium oxide equivalents of aluminium containing compound. In an aspect of the invention the coating formulation between 2.0 and 20 wt% aluminium oxide equivalents of aluminium containing compound.

In an aspect of the invention the coating formulation comprises at least 0.1 wt%, at least 0.5 wt%, at least 1 wt%, at least 2 wt%, at least 3 wt%, at least 5 wt%, at least 7wt% at least 10wt%, at least 12 wt % aluminium oxide equivalents of aluminium containing compound.

In an aspect of the invention the coating formulation comprises 30 wt% or less, 25 wt% or less, 22 wt% or less, 20 wt% or less, 18 wt% or less, 14 wt % or less aluminium oxide equivalents of aluminium containing compound.

The wt% alumina in the coating formulation may be expressed as

$$Al_2O_3\,wt\% = \frac{weight\;Al_2O_3}{weight\;Al_2O_3\;+\;weight\;SiO_2} * 100$$

In further aspect of the invention, the objective is achieved by a method of preparing a coated substrate comprising the steps of:

-   providing a substrate;
-   providing a coating formulation according to any one of the embodiments as described herein;
-   applying the coating formulation on the substrate;
-   drying the applied coating formulation on the substrate; and
-   converting the dried coating formulation on the substrate into a coated substrate.

A method of preparing a coated substrate comprising the steps of:

- providing a substrate having a first surface;
- providing a coating formulation as described herein;
- applying the coating formulation on the first surface of the substrate;
- drying the applied coating formulation; and
- converting the substrate with dried coating formulation into a coated substrate comprising a coating layer on the first surface, for example by heating, such as by heating above 400 degrees Celsius.

In an aspect a base coating as described herein forms at least a part of the first surface of the substrate. In an aspect a base coating as described herein forms the first surface of the substrate.

In a further aspect of the invention, the objective is achieved by a coated substrate obtainable by a method as described herein, including a method comprising the steps of

- providing a substrate;
- providing a coating formulation according to any one of the embodiments as described herein;
- applying the coating formulation on the substrate;
- drying the coating formulation on the substrate; and
- converting the coating formulation on the substrate into a coated substrate.

The present invention further elates to a coated substrate comprising:

   i. a substrate; and
   ii. a porous anti-reflective coating layer arranged on at least a part of the substrate,

wherein the anti-reflective coating layer comprises

- pores with a diameter in the range of 10 to 120 nm, preferably 30 to 100 nm as measured using ellipsometry and / or electron microscopy; and
- elongated dense inorganic oxide particles with an aspect ratio of at least 2, and a smaller diameter in the range of 3 to 20 nm; and
- between 0.1 to 30 wt-% aluminium oxide equivalents of aluminium containing compound, preferably 0.5 to 30 wt-% aluminium oxide equivalents of aluminium containing compound.

The present invention further elates to a coated substrate comprising:

   i. a substrate; and
   ii. a porous anti-reflective coating layer arranged on at least a part of the substrate,

wherein the anti-reflective coating layer comprises

- pores with a diameter in the range of 10 to 120 nm, preferably 30 to 100 nm as measured using ellipsometry and / or electron microscopy; and
- elongated dense inorganic oxide particles with an aspect ratio of at least 2, and a smaller diameter in the range of 3 to 20 nm; and
- between 0.1 to 30 wt-% aluminium oxide equivalents of aluminium containing compound, preferably 0.5 to 25 wt-% aluminium oxide equivalents of aluminium containing compound.

In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising anionic polymer as porogen, In a further aspect the coating formulation comprises between 0.5 to 20 wt-% aluminium oxide equivalents of aluminium containing compound based on total ash rest after combustion at 600°C, 2 min in air.
In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising neutral polymer as porogen, In a further aspect the coating formulation comprises between 0.5 to 20 wt-% aluminium oxide equivalents of aluminium containing compound based on total ash rest after combustion at 600°C, 2 min in air.
In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising cationic polymer as porogen, In a further aspect the coating formulation comprises between 0.5 to 20 wt-% aluminium oxide equivalents of aluminium containing compound based on total ash rest after combustion at 600°C, 2 min in air.

In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising core-shell nanoparticle as porogen where the core comprises a cationic polymer, and between 0.5 to 20 wt-% aluminium oxide equivalents of aluminium containing compound based on total ash rest after combustion at 600°C, 2 min in air.

In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising core-shell nanoparticle as porogen where the core comprises an anionic polymer, and between 0.5 to 20 wt-% aluminium oxide equivalents of aluminium containing compound based on total ash rest after combustion at 600°C, 2 min in air.

In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising core-shell nanoparticle as porogen where the core comprises a neutral polymer, and between 0.5 to 20 wt-% aluminium oxide equivalents of aluminium containing compound based on total ash rest after combustion at 600°C, 2 min in air.

In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising core-shell nanoparticle as porogen where the core comprises a polyelectrolyte, and between 0.5 to 20 wt-% aluminium oxide equivalents of aluminium containing compound based on total ash rest after combustion at 600°C, 2 min in air.

In a further aspect of the invention, the objective is achieved by a use of a coating formulation comprising elongated inorganic oxide particles with an aspect ratio of at least 2 and a smaller diameter in the range of 3 to 20 nm for improving anti-soiling properties of a substrate, where the coating formulation comprising core-shell nanoparticle as porogen where the core comprises a latex, and between 0.5 to 20 wt-% aluminium oxide equivalents of aluminium containing compound based on total ash rest after combustion at 600°C, 2 min in air. In a further aspect the latex comprises an anionic surfactant micelle and a polymer inside of such micelle. In a further aspect the latex comprises an anionic polyelectrolyte micelle and a polymer inside of such micelle.

In a further aspect the latex comprises a cationic surfactant micelle and a polymer inside of such micelle. In a further aspect the latex comprises an cationic polyelectrolyte micelle and a polymer inside of such micelle.

In a further aspect the latex comprises a neutral surfactant micelle and a polymer inside of such micelle. In a further aspect the latex comprises a neutral surfactant micelle and a polymer inside of such micelle.

Neutral surfactants or Nonionic surfactants have covalently bonded oxygen-containing hydrophilic groups, which are bonded to hydrophobic parent structures, Examples of Neutral surfactants include Alkylphenol ethoxylates such as Triton X-100; Fatty acid esters of glycerol such as, Glycerol monostearate or Glycerol monolaurate; Sulfoxides such as Dimethyl sulfoxide.

An example of a suitable anionic surfactant includes Disponil FES 32 which has a chemical formula, $C_{12}H_{25}(OCH_2CH_2)_4SO_{-4}Na^+$.

An example of a suitable anionic surfactant includes sodium dodecylsulfate.

A latex is defined herein as individual particles colloidally dispersed in a solvent. A latex comprises a surfactant micelle and a polymer inside of such micelle.

An example of suitable surfactant micelle may be a polyelectrolyte.

A surfactant or a surface active agent may be defined as a large molecule with an hydrophobic part and a hydrophylic part anionic.

Micelle is an aggregate of individual components (unimers in this case surfactant) that form the micelle. A micelle may be an aggregate of individual polyelectrolyte molecules. Micelles may be tubular, spherical, vesicle of shape. A polyelectrolyte may be a polymer or a molecule. A polyelectrolyte has more than one charge.

An example of a surfactant is a polyelectrolyte. Polyelectrolytes are polymers of which least one or more of whose repeating units bear an electrolyte group, they may also be referred to as a surfactant with multiple charges on one polymer chain. The surfactant can also have one charge such as a suitable anionic surfactant, for example sodiumdodecylsulphate or Dispenyl FS32.The anionic polymer, may be an anionic PMMA (poly(methyl) methacrylate) ($[CH_2C(CH_3)(CO_2CH_3)]n$) polymer.

If an anionic PMMA polymer is part of the porogen, the porogen particles have a negative surface potential charge.

The PMMA polymer dispersion may typically be obtained via emulsion polymerization of MMA as described in the examples. Different polymers dispersions from PMMA may be prepared as described in examples. The porogens may have an average particles size as measured using DLS of 75, 60 or 32 nm respectively.

If such PMMA polymer dispersion is mixes with an inorganic oxide binder the particles will typically form core-shell nanoparticles after application in a coating layer upon drying by depletion interactions. The PMMA polymer dispersion in that case is used as porogen. Mixing such PMMA polymer dispersion with hydrolyzed silica precursor, applying the mixture to a surface of a substrate and heating the substrate to 400 °C or more result in a coated substrate comprising a substrate and a porous coating on a surface of said substrate. According to the invention also elongated particles are added to the mixture before applying it to the surface.

Such PMMA polymer dispersion may be transformed into core-shell nanoparticles using hydrolyzed silica precursor. Mixing core-shell particles with binder, applying the mixture to a surface of a substrate and heating the substrate to 400 °C or more results in a coated substrate comprising a substrate and a porous coating on a surface of said substrate. According to the invention also elongated particles are added to the mixture.

In an aspect of the invention the polymer may be an anionic polymer. In an aspect of the invention the polymer may be an anionic latex. In an aspect of the invention the polymer may be a neutral latex.

The coating disclosed herein is a porous coating. The coating may be manufactured using a coating formulation comprising a binder and a porogen. The binder comprises inorganic binder particles, such as metaloxide particles, and or an inorganic oxide precursor. The porogen typically comprises an organic material that will decompose, burn, evaporate or be otherwise removed upon exposure to elevated temperature. Typically, the elevated temperature is 400 degrees Celcius or more, such as 550 degrees Celsius or more, such as 600 degrees Celsius or more, such as 650 degrees Celsius or more. Typically, the organic material is an organic polymer. In an aspect the porogen comprises an organic material comprising an organic polymer such as an organic neutral polymer.

In an aspect the porogen comprises an organic cationic polymer. In an aspect the porogen comprises an organic anionic polymer.In an aspect the porogen comprises an organic polymeric polylectrolytes. In an aspect the porogen comprises a combination of at least two of the group conisting of an organic neutral polymer, an organic cationic polymer, and an organic anionic polymer.

The porogen typically comprises an organic polymer core and an inorganic oxide shell around the core. The coating according to the disclosure comprises inorganic particles such as elongated inorganic dense oxide particles. It is noted that elongated inorganic dense oxide particles and elongated dense inorganic oxide particles are used interchangeably herein. It is noted that elongated inorganic dense oxide particles and elongated massive metal oxide particles are used interchangeably herein.

In an aspect of the coating formulation according to the invention the elongated dense inorganic oxide particles accounts for 5 to 70 wt-% of the total amount of inorganic oxide equivalents in the coating formulation, preferably for 5 to 50 wt-% of the total amount of inorganic oxide equivalents in the coating formulation, more preferably for 10 to 45 wt-% of the total amount of inorganic oxide equivalents in the coating formulation, and most preferably for 12 to 30 wt-% of the total amount of inorganic oxide equivalents in the coating formulation. In an aspect of the coating formulation according to the invention the elongated dense inorganic oxide particles accounts for 5 to 15 wt-% of the total amount of inorganic oxide equivalents in the coating formulation.

In an aspect of the coating formulation according to the invention the elongated dense inorganic oxide particles accounts for at least 5 wt% , at least 7 wt% 8 wt%, at least 9 wt%, at least 10 wt%, at least 11 wt%, at least 12 wt%, at least 13 wt%, at least 14wt %, at least 15 wt%, at least 16 wt % , at least 17 wt-%, at least 18 wt%, at least 19 wt%, at least 20 wt%, at least 22 wt%, at least 25 wt based of the total amount of inorganic oxide equivalents in the coating formulation.

In an aspect of the coating formulation according to the invention the elongated dense inorganic oxide particles accounts for 30 wt% or less, 28 wt % or less, 26 wt% or less, 25 wt% or less, 22 wt% or less, 20 wt% or less, 18 wt% or less or 15 wt% or less of the total amount of inorganic oxide equivalents in the coating formulation.

The coating according to the invention comprises pores with a diameter in the range of less than 1 nm up to about 120 nm. The pores may be open pores, such as an opening along a boundary between two particles and optionally connecting to the surface of the coating, and/or the pores may be closed, such as a (closed) hollow particle. Pores that originate from a porogen are also referred to herein as porogen pores. It is preferred that the coating comprises pores with a diameter of 10 to 120 nm, referred to as porogen pores. For pores with a diameter of more than 10 nm, the pore diameter can be estimated by electron microscopy. For pores with a diameter in the range from 2 to 50 nm, porosimetry ellipsometry may be used to determine the pore size distribution. For pores with a diameter below 10 nm, ellipsometry can be used to determine the size. Porogen pores are preferably of substantially regular shape, such as spherical or ellipsoidal (with one or two long axes) pores. In an aspect, porogen pores are preferably of substantially regular shape, such as spherical or ellipsoidal (with one or two long axes) pores,but should not have an aspect ratio of more than 5 as this may negatively influence the mechanical properties of the coating. A hollow particle, such as a hollow inorganic oxide particle may be defined as a particle with an inorganic oxide shell with a hollow core. Porogen pores may be defined by a hollow inorganic oxide particle, such as for example hollow inorganic oxide particles and may originate from core-shell particles having an inorganic oxide (or inorganic oxide precursor) shell and an organic polymer-based core, so that upon curing of the coating the polymer will be removed. Upon curing of the coating formulation the polymer will be decomposed/removed and the coating is formed. Porogen pores may be defined by a hollow inorganic oxide particle, such as for example hollow inorganic oxide particles and may originate from core-shell particles having an inorganic oxide (or inorganic oxide precursor) shell and a core material comprising an organic polymer and/or an organic compound, so that upon curing of the coating the core material will be removed. Upon curing of the coating formulation the core material will be decomposed/removed such that a porous coating is formed. The pore typically originates from an organic porogen, that during conversion of the coating formulation into a functional coating typically will be decomposed, burned, evaporated or otherwise removed.

In an aspect a suitable curing temperature is at least 400 degrees Celsius. In an aspect a suitable curing temperature is at least 550, in an aspect at least degrees 600 Celsius. Pores may also be defined by a combination of inorganic binder particles and/or dense inorganic oxide particles. In this case, the pore typically originates from an organic porogen, such as a polymer particle or another porogen, that during conversion of the coating formulation into a functional coating typically will be decomposed, burned, evaporated or otherwise removed. Porogens include organic neutral, cationic and anionic polymers or polyelectrolytes (see e.g. Fuji, M.; Takai, C.; Rivera Virtudazo, R. V.; Adv. Powder Tech., 2014, 25, 91-100; Zhang, X. et al., App. Mater. Interfaces, 2014, 6, 1415-1423)

In the present disclosure the pore typically originates from an organic porogen, such as a polymer particle or another porogen, that during conversion of the coating formulation into a functional coating typically will be decomposed, burned, evaporated or otherwise removed. It should be observed that conversion does not encompass polymerization of organic (monomeric) compounds as the binder is an inorganic oxide-based binder and the conversion therefore is of a sintering type conversion where organics are at least partially removed, and metal oxide particles at least partially sinter together.

In addition to porogen pores, smaller pores are also present at least in the binder. In the context of the present invention, binder pores are therefore pores with a diameter of 1 to below 10 nm. Binder pores are typically not regular but extended pores in non-contacting regions between adjacent particles of binder, dense inorganic oxide particles and hollow nanoparticles (if present) and may form a network, which may or may not be in connection with the surface of the coating or with the porogen pores.

The coating according to the invention is a porous coating. By porous is herein meant that the coating has pores and a porosity of at least 2%. The maximum porosity depends on mechanical requirements of the coating layer and is typically 50% or less, preferably the porosity is less than 45% and more preferably the porosity is less than 40%. In an aspect such coating layer has a porosity of 2 to 50%. A high porosity generally increases anti-reflective performance but may reduce mechanical strength of a coating. In an aspect the porous anti-reflective coating layer has of porosity of 2% or more, 5% or more, 10% or more, 15% or more, 20% or more, 25% or more, 30% or more. In an aspect the porous anti-reflective coating layer has of porosity 50% or less, 45% or less, 40% or less. In an aspect the porous anti-reflective coating layer has of porosity of 25 to 40%. In an aspect the porous anti-reflective coating layer has of porosity of 30 to 40%.

The porous anti-reflective coating layer may also be referred to herein as coating or anti-reflection coating.

As is well known by the skilled person, image analysis may suitably be performed on a SEM photo. The skilled person will be able to perform image analysis on a SEM photo of a cross section of the coating layer orthogonal to the substrate to determine that the amount of pores having a smallest dimension of at least 10 nm in the region of the AR coating closest to the surface of the substrate is smaller than the amount of pores having a smallest dimension of at least 10 nm in the region of the AR coating closer to the atmosphere.

Alternatively, the skilled person may calculate the porosity from a measured refractive index (RI). Knowing the RI of a coating material without any pores, the skilled person can calculate how much air/pore volume is present in the coating layer. The coating material herein is the total inorganic oxide material after convert the coating formulation into a functional coating for example by heating.

Total inorganic oxide material includes all inorganic oxide material in the coating e.g. material of the binder, plus the material of the inorganic oxide shell, plus aluminium containing compound(s).

In an aspect porosity is determined by image analysis on a SEM photo of a cross section of the coating layer orthogonal to the substrate.

In an aspect of the invention the coating layer of the coated substrate has a porosity of 2 to 50%.

The coating according to the invention also comprises elongated dense inorganic oxide particles with an aspect ratio of at least 2, and a smaller diameter in the range of 3 to 20 nm. Preferably the smaller diameter is in the range of 5 to 20 nm. By elongated is meant that at least one of the dimensions of the particle is much longer, such as at least 2, 3, 4, 5, 8, 10, 15 or 20 times the length of another dimension of the particle. It is preferred that the length of the elongated dense inorganic oxide particle is less than 50 times the length of another dimension of the particle, such as at most, 50, 30, 25, 20 or 15 times the length of another dimension of the particle. When the particle has an irregular shape, the aspect ratio is calculated as the length of the longest straight line from one side of the particle to the other side of the particle (even though this may mean that the straight line may be outside the particle) divided by the shortest dimension of the particle transverse to the longest straight line anyway along the straight line. Examples of elongated dense inorganic oxide particles are IPA-ST-UP (Nissan Chemical) and Levasil CS15/175 (Akzo Nobel) and others are commercially available. Further examples include Levasil CS8-490 and Levasil CS15-150 (Akzo Nobel). Typically the elongated particle has a diameter that is less than its length. In an aspect the elongated dense particles comprises an elongated silica particle having a diameter of from 1 to 30 nm and a length of from 10 to 200 nm. In an aspect the elongated dense particle comprises an elongated silica particle having a diameter from 9 to 15 nm and a length of length from 40 to 100 nm. IPA-ST-UP (Nissan Chemical) is an example of an elongated silica particle having a diameter of from 9 to 15 nm, and a length of length: 40-100 nm.

In an aspect the elongated dense particles is an elongated silica particle having a diameter of from 1 to 30 nm and a length of from 10 to 200 nm.

In an aspect the elongated dense particle is an elongated silica particle having a diameter from 9 to 15 nm and a length of length from 40 to 100 nm. IPA-ST-UP (Nissan Chemical) is an example of an elongated silica particle having a diameter of from 9 to 15 nm, and a length of length: 40-100 nm.

IPA-ST-UP herein refers to ORGANOSILICASOL™ IPA-ST-UP.

The elongated particle has an aspect ratio of at least two and may, without being limited thereto, have an ellipsoidal, a rod-like or an irregular shape. The elongated particle as used in the invention has a longer axis (which may also be referred to as major) having length x1; and a shorter axis perpendicular to the longer axis (which may also be referred to as minor) having a length x2; and an aspect ratio (x1/x2) of at least two.

The aspect ratio is calculated by dividing the length of the longest axis by the smaller axis. The longest axis may also be referred to as major axis. The smaller axis may also be referred to as the minor axis, the smaller diameter or the shortest dimension of the particle. Typically for determining the length of an axis of a particle the outside surface of the particle is used.

By dense is meant that the inorganic oxide particle has low or no porosity, such as a porosity of less than 5 vol-% or no porosity. In an aspect the elongated dense inorganic oxide particle has a porosity of 0.5 - 5 vol-%, in an aspect 1-4 vol-%, in an aspect 1-3 vol-% porosity.

By porogen is herein meant an entity capable of forming pores with a diameter of 10 to 120 nm, preferably 30 to 100 nm, in the final coating may for example be hollow particle; a core-shell particle with a core with a boiling point below the curing temperature of the coating formulation or a core, which is combustable or depolymerizable below the curing temperature; a particle, which is combustable or depolymerizable below the curing temperature. Porogen may also be referred to as pore forming agent. A core with a boiling point below the curing temperature boiling point has a decomposition temperature of below the curing temperature. A core which is combustable or depolymerizable below the curing temperature is a core that is decomposed or depolymerized, or a combiantion thereof, during curing, i.e. at a temperature which is below the curing temparature. As a result the core is removed and a pore is formed.

Thus by porogen, or pore forming agent, is herein meant an entity capable of forming pores with a diameter of 10 to 120 nm, preferably 30 to 100 nm, in the final coating. The porogen may be a polymer particle e.g. a polystyrene particle, Pluronic P123 and / or a PMMA particle. The porogen may for example be hollow particle. The porogen may for example be a hollow silica particle. The porogen may for example be a core-shell particle with a core having a boiling point below the curing temperature of the coating formulation. The porogen may be a core-shell particle with a core that is combustable or depolymerizable below the curing temperature or a particle, that is combustable or depolymerizable below the curing temperature. A core having a boiling point below the curing temperature comprises a material having boiling point of below the curing temperature. A core which is combustable or depolymerizable below the curing temperature comprises a material that is decomposed or depolymerized, or a combination thereof, during curing, i.e. at a temperature below the curing temperature. As a result the compound is removed and a pore is formed.

By oxide equivalents of inorganics is herein meant the metal oxides including silicon oxide irrespective of the actual compound that the inorganic species is present in so for example tetraethoxysilane would count as $SiO_2$ irrespective if the species present is tetraethoxysilane, partially hydrolysed tetraethoxysilane or $SiO_2$. i.e. by oxide equivalents of inorganics is herein meant the equivalent amount of metal oxides including silicon oxide that can be formed from the actual compound or inorganic oxide precursor used. So for example a certain amount of tetraethoxysilane would be expressed as $SiO_2$ equivalent irrespective if the species present is tetraethoxysilane, partially hydrolysed tetraethoxysilane or $SiO_2$. Analogous for Alumina, one calculates the amount of pure $Al_2O_3$ that could be formed. Aluminum oxide equivalents are calculated back to theoretical $Al_2O_3$ amount based on the alumina precursor added to the formulation.

The alumina precursor may include

- Al(III) complexes such as halogen-based salts of Al(III) in the form of AlX3 where X can be F, Cl, Br, I and their hydrate form;

- Al(III) inorganic salts such as Al(III) nitrates, nitrites, sulfites, sulfates, phosphates, chlorates, perchlorates, carbonates and their hydrate form;

- Al(III) complexes bearing oxygen or nitrogen donor based ligands which are hydrolysable such as alkoxides or amides; and

- combinations thereof.

The alumina precursor may include any of Al(isopropoxide)3, Al(sec-butoxide)3, Al(NO3)3, AlCl3 or a combination thereof.

The silica precursor may include TEOS (tetraethoxysilane), TMOS (tetramethoxysilane), alkylsilanes such as (R)x)Si (OCH3)4-x where R=CH3; C2H5; OCH3 of OC2H5 or a combination thereof.

In an aspect the inorganic oxide equivalents of the coating formulation are based on total ash rest after combustion at 600°C, 2 min in air. As the skilled person knows total ash rest after combustion at 600°C, 2 min in air is the total residual solid material after combustion at 600°C, 2 min in air.

For instance for silica, one starts from alkoxysilane. When it is refered to oxide equivalents, the assumption is made that only pure $SiO_2$ is formed. Analogous for Alumina, if started from Al(NO3)3 one calculates the amount of pure $Al_2O_3$ that could be formed.

For example for 10 grams of tetraethyl orthosilicate (TEOS), the amount of inorganic oxide equivalents is calculated as follows:

$$\text{eq. } SiO_2 = \frac{amount\ TEOS\ [g]}{Mw\ TEOS} * Mw\ SiO_2$$

i.e. eq. $SiO_2$ = oxide equivalents of inorganics = 10/ 208,33*60,08 = 2,88 g

For example for 1 gram elongated dense inorganic oxide particles with an aspect ratio of at least 2 and an average smaller diameter in the range of 3 to 20 nm), the amount of inorganic oxide equivalents is calculated as follows: The elongated particles used in the examples are considered to be pure $SiO_2$. So 1 gram elongated particles, is equivalent to 1 g inorganic oxide (here 1 gram SiO2).

In one embodiment, the porogen account for a significant part of the total amount of inorganic oxide in the coating formulation. Preferably, the porogen accounts for 10 to 75 wt-% of the total amount of inorganic oxide in the coating formulation, and more preferably the porogen accounts for 20 to 50 wt-% of the total amount of inorganic oxide in the coating formulation. This may for example be the situation when the porogen is a core shell particle or a hollow particle.

In another embodiment, the elongated dense inorganic oxide particles account for a significant amount of the inorganic oxide in the coating formulation. Preferably the elongated dense oxide particles account for 5 to 70 wt-% of the total amount of inorganic oxide in the coating formulation, more preferably for 5 to 50 wt-% of the total amount of inorganic oxide in the coating formulation, and even more preferably for 10 to 45 wt-% of the total amount of inorganic oxide in the coating formulation, such as 12 to 30 wt-% of the total amount of inorganic oxide in the coating formulation. In an aspect of the coating formulation according to the invention the elongated dense inorganic oxide particles accounts for 5 to 15 wt-% of the total amount of inorganic oxide in the coating formulation. In an aspect of the coating formulation according to the invention the elongated dense inorganic oxide particles accounts for at least 5 wt% , at least 7 wt% 8 wt%, at least 9 wt%, at least 10 wt%, at least 11 wt%, at least 12 wt%, at least 13 wt%, at least 14wt %, at least 15 wt%, at least 16 wt % , at least 17 wt-%, at least 18 wt%, at least 19 wt%, at least 20 wt%, at least 22 wt%, at least 25 wt based of the total amount of inorganic oxide in the coating formulation. In an aspect of the coating formulation according to the invention the elongated dense inorganic oxide particles accounts for 30 wt% or less, 28 wt % or less, 26 wt% or less, 25 wt% or less, 22 wt% or less, 20 wt% or less, 18 wt% or less or 15 wt% or less of the total amount of inorganic oxide in the coating formulation.

The inorganic oxide may be any oxide known from glass coatings. The inorganic oxide may be any known from glass coatings including metal oxides such as for example $Al_2O_3$, $SiO_2$, $TiO_2$, $ZrO_2$, oxides of lanthanides and mixtures (including mixed oxides) thereof. The inorganic oxide may be any known from glass coatings including metal oxides, compounds and mixtures comprising for example $Al_2O_3$, $SiO_2$ and optionally one or more of of Li2O, BeO, BaO, MgO, K2O, CaO, MnO, NiO SrO, FeO, Fe2O3, CuO, Cu2O, CoO, ZnO, PbO, GeO2, SnO2, Sb2O3, Bi2O3. It is preferred that the inorganic oxide contains silica, preferably the inorganic oxide contains at least 50 wt-% silica and more preferably the inorganic oxide is at least 90 wt-% silica, such as the inorganic oxide consisting of silica.

The coated substrate according to the invention may for example be prepared by a method comprising the steps of providing a substrate; providing a coating formulation according to the invention; apply the coating formulation on the substrate; drying the coating formulation on the substrate; and converting the coating formulation on the substrate into a coated substrate. It should be observed that the conversion does not involve polymerization of an organic polymer but rather a consolidation of the binder and/or conversion of the porogen into a pore in the coating. This may be by heating for example combined with a tempering process of a glass substrate, but may alternatively involve evaporation of solvent in a solvent templated particle, which may take place at a much lower temperature.

In case the core comprises a solvent, e.g. in a solvent templated particle, conversion of the porogen into a pore may involve evaporation of solvent, for example at temperature below 250 °C. The solvent may have a boiling point of at most 250 °C, or at most 200, 175 or 150 °C. In such situation, a substrate comprising an applied coating formulation according to the invention is converted into a coated substrate comprising a coating layer on the first surface by exposing the applied coating formulation to a temperature of below 250°C. In an aspect by exposing the applied coating formulation to a temperature of below 200, below 175 or below 150 °C.

An anti-reflective coating comprising IPA-ST-UP particles (elongated particles) and inorganic binder is disclosed in WO2007/093341. However, WO2007/093341 does not indicate any relevance to anti-soiling properties and does not disclose presence of pores having a diameter of 10-120 nm in the coating, and particularly not pores of a diameter of 30-100 nm.

When the coating is applied to a substrate, such as a glass sheet, the coating will have an inner surface facing towards the substrate and an outer surface facing away from the substrate. In one embodiment, the elongated dense inorganic oxide particles are not distributed homogeneously in the coating. Particularly, it was found to be advantageous that the mass ratio of inorganic oxide originating from elongated dense inorganic oxide particles to total inorganic oxide of the coating is higher in or near the outer surface of the coating. Here, outer surface refers to the surface of the coating away from the substrate, which surface typically is exposed to the atmosphere.

$$\left(\frac{M_{\text{elongated } massive\ metal\ oxide\ particles}}{M_{total\ metal\ oxide}}\right)_{Surface} > \left(\frac{M_{\text{elongated } massive\ metal\ oxide\ particles}}{M_{total\ metal\ oxide}}\right)_{Average}$$

The distribution may for example be determined by STEM-EDX or by depth profiling. Thus the distribution of elongated dense inorganic oxide particles in a coating may for example be determined by STEM-EDX or by depth profiling. This is particularly advantageous when the chemical composition of the dense inorganic oxide particles and the overall formulation is not the same.

In an aspect of the coating according to the invention the mass ratio of inorganic oxide originating from elongated dense inorganic oxide particles to total inorganic oxide of the coating is higher in or near the outer surface of the coating as compared to a reference coating. A suitable reference coating may be a coating without elongated dense inorganic oxide particles.

It was found to be advantageous if the ratio is higher in the 20 nm of the coating closest to the outer surface than the average mass ratio of the inorganic oxide originating from elongated dense inorganic oxide particles to total inorganic oxide of the coating. In an aspect the ratio of inorganic oxide originating from elongated dense inorganic oxide particles to total inorganic oxide of the coating is at least 50% higher in the 20 nm of the coating closest to the outer surface compared to the average ratio of the inorganic oxide originating from elongated dense inorganic oxide particles to total inorganic oxide of the coating. Particularly, it was found to be advantageous when the ratio is higher in the 20 nm of the coating closest to the outer surface that the average mass ratio of the inorganic oxide originating from elongated dense inorganic oxide particles to total inorganic oxide of the coating. Preferably the ratio of inorganic oxide originating from elongated dense inorganic oxide particles to total inorganic oxide of the coating is at least 50% higher in the 20 nm of the coating closest to the outer surface that the average ratio of the inorganic oxide originating from elongated dense inorganic oxide particles to total inorganic oxide of the coating, and more preferably the ratio of inorganic oxide originating from elongated dense inorganic oxide particles to total inorganic oxide of the coating is at least twice as high in the 20 nm of the coating closest to the outer surface that the average ratio of the inorganic oxide originating from elongated dense inorganic oxide particles to total inorganic oxide of the coating. It could be theorized without being limited thereto that improved anti-soiling properties associated with this distribution of the elongated dense inorganic oxide particles is related to the slight change in surface morphology observed when elongated dense inorganic oxide particles are arrange near or at the surface of the coating.

In an aspect the coated substrate according to the invention demonstrates the mass ratio of inorganic oxide originating from the elongated dense inorganic oxide particles to total inorganic oxide of the coating being higher in a 20 nm thick top layer of the coating closest to the outer surface of the coated substrate than the average mass ratio of the inorganic oxide originating from dense inorganic oxide particles to total inorganic oxide of the coating.

In an aspect the mass ratio of inorganic oxide originating from the dense inorganic oxide particles to total inorganic oxide of the coating is at least 50% higher in the top layer of the coating than the average mass ratio of the inorganic oxide originating from elongated dense inorganic oxide particles to total inorganic oxide of the coating. In an aspect the mass ratio of inorganic oxide originating from the elongated dense inorganic oxide particles to total inorganic oxide of the coating is at least twice as high in the top layer the coating than the average mass ratio of the inorganic oxide originating from dense inorganic oxide particles to total inorganic oxide of the coating.

The coating according to the invention shows improved anti-soiling properties. The improved anti-soiling properties may be demonstrated by an increased Anti-Soiling Ratio (ASR) as defined by:

$$ASR = \frac{(T_{Substrate,0} - T_{Substrate,soil}) - (T_{Coating,0} - T_{Coating,soil})}{(T_{Substrate,0} - T_{Substrate,soil})} \times 100\%,$$

where "T" is the average transmittance from 380-1100 nm measured by a spectrophotometer, Substrate refer to substrate without coating, Coating refers to the substrate with double sided coating. "0" refer to the measured transmittance before the soil test and "soil" refers to transmittance after soil test. From 380-1100 nm herein means the in wavelength region from 380nm to 1100 nm including 1100 nm. In an aspect "T" is the average transmittance from 380-1100 nm measured by a Shimadzu UV2600 spectrophotometer. In an aspect "T" is the average transmittance from 380-1100 nm measured by an Optosol Transpec VIS-NIR spectrophotometer. In an aspect the coated substrate demonstrates an ASR of at least 50%. In an aspect the coated substrate demonstrates an ASR of at least 75%. In an aspect the coated substrate demonstrates an ASR of at least 80%. In an aspect the coated substrate demonstrates an ASR of at least 90%.

The soil test is conducted as described in the experimental part.

A soil test may include:

    a) Providing a substrate with a surface to be tested;
    b) Cleaning the surface to be tested to obtain a cleaned surface;
    c) Measuring the transmittance from 380-1100 nm of the cleaned surface before soiling and determining the average transmittance in the range from 380 to 1100 nm (T0);
    d) Soiling the surface to be tested with dust to obtain a dusted soiled surface;
    e) Oscillating the substrate having the dusted surface;
    f) removing excess dust from the dusted surface to obtain a soiled surface; and
    g) measuring the transmittance from 380-1100 nm of the soiled surface after soiling (transmittance after soiling) and determining the average transmittance in the range from 380 to 1100 nm (Tsoil).

This way the following values may be obtained:

-    in step c) $T_{Substrate,0}$: the average transmittance from 380-1100 nm of the uncoated glass surface (substrate without coating) before soil test;

-    in step g) $T_{Substrate,soil}$: the average transmittance from 380-1100 nm of the uncoated glass surface after soil test;

-    in step c) $T_{Coating,0}$: the average transmittance from 380-1100 nm of the coated glass surface (coating with double sides coating) before soil test;

-    in step g) $T_{Coating,soil}$: the average transmittance from 380-1100 nm of the coated glass surface after soil test.

$T_{Coating,0}$ may also be referred to herein as $T_{coated\ substrate,0}$ or $T_{coated\ substrate\ with\ Al,0}$ or $T_{coated\ substrate\ without\ Al,0}$.

$T_{Coating,soil}$ may also be referred to herein as $T_{coated\ substrate,soil}$ or $T_{coated\ substrate\ with\ Al,soil}$ or $T_{coated\ substrate\ without\ Al,soil}$.

In step e) of the soil test Oscillating may be done by 300 cycles at a speed of 100 cycles per minute; one cycle being defined as a full revolution of the circular drive disk: one completed back-and-forth movement of the tray of a Taber Oscillating table.

In step f) of the soil test removing excess dust may be done by manually gently tapping a thin edge of the substrate (the side of the glass plate) on a hard surface, such as a table top.

Removing excess dust may be followed by cleaning the back side (the front side being the surface to receive the incident light in the spectrophotometer) of the soiled substrate (soiled glass plate) by gently wiping the backside surface with a soft cloth;

In an aspect cleaning comprises: cleaning with deionized water and a soft cloth, rinsing with laboratory grade ethanol and leaving to dry overnight.

Preferably cleaning is done at a relative humidity of below 40%.

Soil test and soiling test are used interchangeably herein.

Herein the average transmittance from 380-1100 nm means the average transmittance value in the wavelength range of 380 to 1100 nm.

In an aspect the transmittance is measured using an Optosol Transpec VIS-NIR spectrophotometer.

In an aspect the transmittance is measured using an Shimadzu UV2600 spectrophotometer.

In an aspect the soil test, in particular step d) and e) above, is performed using a Taber Oscillating Abrasion Tester (such as model 6160).

ASR indicates how well the coating improves the anti-soiling properties of the substrate. An ASR of 50% hence means that the coating only loses half the transmittance compared to the transmittance loss of the naked substrate. A naked substrate herein is a substrate without a coating layer, e.g. an uncoated piece of glass. Preferably the substrate-coating ASR of the coating is at least 75%, more preferably the substrate-coating ASR is at least 80%, and most preferably the substrate-coating ASR is at least 90%. ASR cannot be higher than 100% since this would mean that the coating is better after soiling, so the ASR should be maximum 100%.

The improved anti-soiling properties may be demonstrated by an increased

Anti-Soiling Gain (ASG) with, ASG =

$$\left[ 1 - \frac{\left(T_{coated\ substrate\ with\ Al,0} - T_{coated\ substrate\ with\ Al,soil}\right)}{\left(T_{coated\ substrate\ without\ Al,0} - T_{coated\ substrate\ without\ Al,soil}\right)} \right] \times 100\%$$

where T is the is the average transmittance from 380-1100, Coated Substrate with Al refers to a double side coated substrate with the coating with alumina and elongated particles and Coated Substrate without Al refers to a double side coated substrate with same coating where the alumina and dense inorganic oxide particles are excluded, 0 refer to before soil test and soil refer to after soil test, 0 refers to before soil test and soil refer to after soil test.

In an aspect the coated substrate according to the invention demonstrates by an Anti-Soiling Gain (ASG) of at least 50%, in an aspect of at least 75%. The invention provides a coated substrate having an Anti-Soiling Gain, ASG, with

$$ASG = \left[ 1 - \frac{\left(T_{coated\ substrate\ with\ Al,0} - T_{coated\ substrate\ with\ Al,soil}\right)}{\left(T_{coated\ substrate\ without\ Al,0} - T_{coated\ substrate\ without\ Al,soil}\right)} \right] \times 100\%$$

of at least 50%, preferably the ASG is at least 75%, where T is the is the average transmittance from 380-1100 nm, Coated Substrate with Al refers to a double side coated substrate with the coating with alumina and elongated particles and Coated Substrate without Al refers to a double side coated substrate with same coating where the alumina and dense inorganic oxide particles are excluded, 0 refers to before soil test and soil refers to after soil test.

The coating according to the invention was also found to often fulfill the requirement that the antisoiling gain, ASG Coated substrate according to any one of the embodiments 3 to 7 as disclosed herein, wherein the coated substrate has an Antisoiling gain, ASG,

$$ASG = 1 - \frac{\left(T_{coated\ substrate\ with\ Al,0} - T_{coated\ substrate\ with\ Al,soil}\right)}{\left(T_{coated\ substrate\ without\ Al,0} - T_{coated\ substrate\ without\ Al,soil}\right)}$$

of at least 50%, preferably the ASG is at least 75%, where T is the is the average transmittance from 380-1100 nm measured by a Shimadzu UV2600 spectrophotometer. Coated Substrate with Al refer to a double side coated substrate with the coating with alumina and elongated particles and Coated Substrate without Al refer to a double side coated substrate with same coating except the alumina and dense inorganic oxide particles are excluded, 0 refer to before soil test and soil refer to after soil test. 0 refer to before soil test and soil refer to after soil test.

In an aspect the invention provides a coated substrate obtainable by the method of preparing a coated substrate according to the invention, demonstrating improved anti-soiling properties.

In an aspect the invention provides a coated substrate comprising:

  i. a substrate; and
  ii. a porous anti-reflective coating layer arranged on at least a part of the substrate,

wherein the anti-reflective coating comprises

- pores with a diameter in the range of 10 to 120 nm, preferably 30 to 100 nm as measured using ellipsometry and / or electron microscopy; and
- elongated dense inorganic oxide particles with an aspect ratio of at least 2, and a smaller diameter in the range of 3 to 20 nm; and
- between 0.1 to 30 wt-% aluminium oxide equivalents of aluminium containing compound, preferably 0.5 to 30 wt-% aluminium oxide equivalents of aluminium containing compound.

The wt-% aluminium oxide equivalents of aluminium containing compound in the antireflective coating may be determined using STEM EDX. Alternatively it may be determined using ToF-SIMS.

In an aspect of the invention the anti-reflective coating layer comprises at least 0.1 wt%, at least 0.5 wt%, at least 1 wt%, at least 2 wt%, at least 3 wt%, at least 5 wt% at least 7wt% at least 10wt%, at least 12 wt % aluminium oxide equivalents of aluminium containing compound.

In an aspect of the invention the anti-reflective coating comprises 30 wt% or less, 25 wt% or less, 22 wt% or less, 20 wt% or less, 18 wt% or less, 14 wt % or less aluminium oxide equivalents of aluminium containing compound.

The porous anti-reflective coating layer may also be referred to herein as coating.

The substrate is a solid material, such as a polymer sheet or a glass member. The substrate may include quartz or polymer foil, such as glass foil. Examples of polymer substrates are plastic foils and polymers based on one or more of the polymers selected from Polyethylene terephthalate (PET), Polymethyl methacrylate (PMMA), Polyethylene naphthalate (PEN), polycarbonate (PC). A further example of a polymer substrate includes polyimide (PI). Polymer substrates may be advantageous for flexible solar cells. Preferably the substrate is transparent. In an aspect the substrate is having an average transmission of at least 80% in the range of 380 -1100 nm.

Preferably, the substrate is a glass member being selected from the group of float glass, chemically strengthened float glass, borosilicate glass, structured glass, tempered glass and thin flexible glass having thickness in the range of for example 20 to 250 $\mu$m such as 50 to 100 $\mu$m as well as substrates comprising a glass member, such as a partially or fully assembled solar module and an assembly comprising a glass member. The glass member may be SM glass or MM glass. A commercially available MM glass includes Interfloat GMB SINA 3.2mm solar glass for photovoltaic applications.

In an aspect of the invention the coated substrate is a cover glass for a solar module.

The invention further relates to a solar module comprising a coated substrate as described herein.

Solar modules are modules typically comprise a glass member forming at least a part of the first surface of the substrate and at least one member selected from the group consisting of thin film transparent conductive and/or semiconductor layers, a back sheet, an encapsulant, solar cells, an electrical conducting film, wiring, controller box and a frame.

The glass member may be selected from the group of float glass, chemically strengthened float glass, borosilicate glass, structured glass, tempered glass and thin flexible glass having thickness in the range of for example 20 to 250 $\mu$m such as 50 to 100 $\mu$m. Preferred substrates for the method according to the invention are hence tempered glass, chemically strengthened glass and substrates comprising temperature sensitive components, such as partially or fully assembled solar cell modules. In one embodiment, the substrate comprises a transparent solid sheet member with a base coating on a first side of the sheet member so the base coating forms at least a part of the first surface of the substrate, to be coated with the single non-laminated layer coating layer. Preferably, the base coating is selected from the group of barrier coatings, such as sodium barrier coatings, and anti-reflective coatings.

In an aspect the coated substrate according to the invention comprises a transparent solid sheet member, and a base coating layer interposed between the first surface and the coating layer on the first coating, preferably the base coating is selected from the group of barrier coatings and anti-reflective coatings.

In an aspect the substrate is transparent solid sheet member with a base coating on a first side of the sheet member so the base coating forms at least a part of the first surface of the substrate. In an aspect the substrate is transparent solid sheet member with a base coating on a first side of the sheet member so the base coating forms the first surface of the substrate.

The coating according to the invention is preferably an anti-reflective coating. In an aspect according to the invention the coated substrate demonstrates an ARE of at least 2%, at least 3%, at least 4%, at least 5%.

In an aspect the coated substrate according to the invention demonstrates a substrate-coating anti-reflective effect, ARE, with

$$ARE = T_{Coated\ substrate,0} - T_{Substrate,0}$$

of at least 2%, preferably the ARE is at least 3%, more preferably the ARE is at least 4%, where T is the is the average transmittance in the wavelength range from 380-1100 nm, Substrate refers to substrate without coating, Coated substrate refers to the substrate with double sided coating and 0 refers to before soil test. In an aspect T is the average transmittance from 380-1100 nm measured by a Shimadzu UV2600 spectrophotometer. In an aspect T is the average transmittance from 380-1100 nm measured by an Optosol Transpec VIS-NIR spectrophotometer.

The coating according to the invention is particularly suitable for lowering the reflectivity of a transparent substrate for example any type of glass substrate, hence being used as an anti-reflective coating.

Another aspect of the invention relates to a coating formulation comprising a porogen capable of forming pores with a diameter of 10-120 nm, elongated dense inorganic oxide particles with an aspect ratio of at least 2 and a smaller diameter in the range of 3 to 20 nm, an inorganic binder, a solvent and 0.5 to 30 wt-% aluminium oxide equivalents of aluminium containing compound. Aluminium and aluminium are used interchangeably herein. In an aspect the aluminium oxide equivalents of aluminium containing compound are based on total ash rest after combustion at 600°C, 2 min in air. The aluminium may be provided for example as metal oxide powder, but more preferably as an organic or inorganic salt optionally in solution or suspension. In a preferred embodiment, the coating formulation comprises between 1.0 to 25 wt-% aluminium oxide equivalents of aluminium containing compound as it was found that the stability in the sense of shelf life was best for aluminium concentrations in this range. Stability refers to the stability of the coating formulation. The stability of the coating formulation may be assessed by looking at the homogeneity of the coating formulation. An inhomogeneous coating formulation indicates a low stability and low shelf life. The inhomogeneity of the formulation can be directly observed by the presence of sediments or gel formation in the liquid formulation or can be measured by DLS (Dynamic Light Scattering) via the growth or aggregation of colloidal particles in the suspension over time. Using an inhomogeneous coating formulation typically results in a non-homogeneous coating.

In an aspect the coating formulation according to the invention comprises

> i. at least 2 wt-% based on oxide equivalents of inorganics of elongated inorganic dense oxide particles with an aspect ratio of at least 2 and an average smaller diameter in the range of 3 to 20 nm as measured by TEM, and
> ii. a porogen capable of forming pores with a diameter in the range of 10 to 120 nm,
> iii. an inorganic oxide binder, and
> iv. a solvent,

wherein the coating formulation comprises between 0.5 to 30 wt-% aluminium oxide equivalents of aluminium containing compound based on total ash rest after combustion at 600°C, 2 min in air, preferably the coating formulation comprises between 1.0 to 25 wt-% aluminium oxide equivalents of aluminium containing compound based on total ash rest after combustion at 600°C.

The porogen may for example be hollow inorganic oxide particles, or core-shell particles having an inorganic oxide (or inorganic oxide precursor) shell and a core comprising an organic compound, such as a cationic, anionic or neutral polymer or an organic compound with a boiling point below 200°C. The porogen may also be an organic porogen, such as organic nano particle like for example an organic polymeric nano-particle or another porogen, that during conversion of the coating formulation into a functional coating typically will be decomposed, burned, evaporated or otherwise removed. By organic nano particle is herein meant a particle comprising one or more organic molecules and having a size in the range of 50 to 150nm. Examples of organic molecules are polymers, such as acrylic polymers and latexes; and oligomers. The elongated dense inorganic oxide particle is discussed above.

In an aspect of the invention, the porogen comprises

> - core-shell nanoparticles where the core comprises an organic compound, such as a polymer or an organic compound with a boiling point below 200°C, and the shell comprises an inorganic oxide; and
> - hollow inorganic nanoparticles.

In an aspect of the invention the porogen accounts for 10 to 75 wt-% of the total amount of inorganic oxide equivalents in the coating formulation. In an aspect the porogen accounts for 20 to 50 wt-% of the total amount of inorganic oxide equivalents in the coating formulation.

The inorganic binder typically comprises inorganic oxide particles with a diameter in the range of 0.1 to 7 nm and/or an inorganic oxide precursor with a diameter in the range of 0.1 to 7 nm. The inorganic binder is preferably an inorganic oxide particle or inorganic oxide precursor with a diameter in the order of 0.1 to 7 nm.

It is noted that the inorganic oxide particles may have a diameter of more than 7 nm, e.g. in the range of 7 to 10 nm. It is noted that the inorganic oxide precursor may have a diameter of more than 7 nm, e.g. in the range of 7 to 10 nm.

In an aspect of the invention the inorganic binder comprises inorganic oxide nano particles with an average diameter in the range of 0.1 to 7 nm.

In an aspect the inorganic binder typically comprises inorganic oxide particles with a diameter in the range of 0.1 to 5 nm and/or an inorganic oxide precursor with a diameter in the range of 0.1 to 5 nm.

The diameter of the inorganic oxide particle and/ or the inorganic oxide precursor may be measured with Dynamic Light Scattering (DLS). Examples are pre oligomerized silicon alkoxide such as pre oligomerized tetraethoxysilane, pre oligomerized titanium alkoxide and metal oxide sol gels. An example of an inorganic oxide particle and/ or the inorganic oxide precursor includes metal oxide sols. Pre oligomerized silicon alkoxide is also referred to by the skilled person as pre oligomerized silicon alkoxide. An inorganic binder may for example be prepared as described in WO 2009/106456 (incorporated herein by reference).

The coating formulation according to the invention comprises a solvent. The solvent can be any solvent, combination of solvents or combination of solvents and additives, such as surfactants and stabilizers, that can realize a stable dispersion of the coating formulation. Typically, the solvent accounts for 80 - 98% of the mass of the coating formulation. Highly suitable solvents are isopropanol (IPA), water or combinations of solvents including IPA and/or water.

The coating formulations according to the invention comprises elongated dense inorganic oxide particles with an aspect ratio of at least 2, and a smaller diameter in the range of 3 to 20 nm in a coating on a substrate for improving anti-soiling properties of a substrate. It was highly unexpected that the shape of the dense inorganic oxide particles appeared to have a major influence on the anti-soiling properties of the coating and that it hence was possible to reduce the sensitivity to soiling of a substrate by coating it with a coating where elongated dense inorganic oxide particles were included. A coating prepared from a coating formulation comprising non-spherical particles such as elongated particles, in particular elongated dense inorganic oxide particles, demonstrates improved anti-soiling properties as compared to a coating prepared from a coating formulation without elongated dense inorganic oxide particles. In an aspect a coating prepared from a coating formulation comprising non-spherical particles such as elongated particles, in particular elongated dense inorganic oxide particles, demonstrates improved anti-soiling properties as compared to a coating prepared from a coating formulation comprising spherical particles. In other words, this method of reducing sensitivity to soiling of a substrate includes the steps of applying a coating formulation containing elongated dense inorganic oxide particles to a substrate and convert the coating formulation into a functional coating for example by heating.

Another aspect of the invention concerns a solar module comprising a coated substrate according to the invention. Another aspect of the invention concerns a solar module comprising a coated substrate as described herein. Such solar module exhibits significantly better performance over time at lower operational costs. The reason for that being the reduced frequency of cleaning or the improved power output at the same frequency of cleaning, all of which become possible due to the enhanced anti-soiling properties of the coating of the invention that significantly reduces the soiling of said solar module. Other advantageous devices comprising the coated substrate according to the invention are greenhouse glass (or polymer membrane), concentrated solar modules, windows, displays. In some applications, such as for example roof top coating or container surfaces, the substrate may be non-transparent and the advantage of the invention is there focused on the ability of the anti-soiling coating to reduce collection of dirt on the substrate or to enhance cleanability of the coated substrate as compared to the uncoated substrate.

The coating formulation may be applied to a substrate by any known technique in the art, for example dipping, brushing, spraying, spinning, slot die coating, aerosol coating or via the use of a roller. Spraying can be airless or with the use of conventional air, or electrostatic, or high volume/low pressure (HVLP) or aerosol coating. It is preferred that the coating formulation is applied by roll coating, aerosol coating or dip coating.

By functional coating is meant a coating that enhances mechanical, optical and/or electrical properties of the substrate to which the functional coating is attached. Examples of possible enhanced mechanical properties of a substrate coated with the coating of the invention are increased surface hardness, increased stiffness or wear properties as compared to the mechanical properties of the uncoated substrate. Examples of possible enhanced optical properties of a substrate coated with the coating of the invention are increased light transmittance from air through the functional coating and substrate compared to light transmittance directly from air through the substrate, and reduced reflectance from the interphase from air to the functional coating and the functional coating to the substrate compared to the reflectance directly from air to uncoated substrate. Examples of possible enhanced electrical properties of a substrate coated with the coating of the invention are increased conductivity as compared to the unconverted coating and/or to the uncoated substrate.

Another aspect of the invention concerns the use of a coating formulation comprising elongated inorganic oxide particles with an aspect ratio of at least 2 and a smaller diameter in the range of 3 to 20 nm for improving anti-soiling properties of a substrate. Particularly, this embodiment concerns a coating formulation comprising core-shell nanoparticle as porogen where the core comprises an organic compound, such as a anionic polymer, and between 0.5 to 20 wt-% aluminium oxide equivalents of aluminium containing compound based on total ash rest after combustion at 600°C, 2 min in air. Another aspect of the invention includes the use of a coating formulation as described herein for improving anti-soiling properties of a substrate, such as a cover glass for a solar module.

Another aspect of the invention includes the use of the combination of

- elongated dense inorganic oxide particles having an aspect ratio of at least 2 and a smaller diameter in the range of 3 to 20 nm; and

- an aluminium containing compound,

to improve anti-soiling properties of a substrate.

Another aspect of the invention includes the use of elongated dense inorganic oxide particles with an aspect ratio of at least 2, and a smaller diameter in the range of 3 to 20 nm to reduce the soiling of a solar module.

Another aspect of the invention includes the use of the combination of

- elongated dense inorganic oxide particles having an aspect ratio of at least 2 and a smaller diameter in the range of 3 to 20 nm; and
- an aluminium containing compound,

to reduce the soiling of a solar module.

Embodiments of the invention include the following:

1. A coating formulation comprising

> i. at least 2 wt-% based on oxide equivalents of inorganics of elongated inorganic dense oxide particles with an aspect ratio of at least 2 and an average smaller diameter in the range of 3 to 20 nm as measured by TEM, and
> ii. a porogen capable of forming pores with a diameter in the range of 10 to 120 nm,
> iii. an inorganic oxide binder, and
> iv. a solvent,

wherein the coating formulation optionally comprises between 0.5 to 30 wt-% aluminium oxide equivalents of aluminium containing compound based on total ash rest after combustion at 600°C, 2 min in air, preferably the coating formulation comprises between 1.0 to 25 wt-% aluminium oxide equivalents of aluminium containing compound based on total ash rest after combustion at 600°C, and wherein the porogen comprises an anionic polymer.

2. The coating formulation according to any one of the preceding embodiments, wherein the porogen comprises an anionic PMMA polymer.

3. The coating formulation according to any one of the preceding embodiments, wherein the porogen comprises core-shell nanoparticles, wherein the core comprises an anionic PMMA polymer and the shell comprises an inorganic oxide.

4. The coating formulation according to any one of the preceding embodiments, wherein the porogen account for 10 to 75 wt-% of the total amount of inorganic oxide in the coating formulation, preferably the porogen accounts for 20 to 50 wt-% of the total amount of inorganic oxide in the coating formulation.

5. The coating formulation according to any one of the preceding embodiments, wherein the inorganic binder comprises inorganic oxide nano particles with a number average diameter in the range of 0.1 to 7 nm.

6. The coating formulation according to any one of the preceding embodiments, wherein the elongated dense inorganic oxide particles account for 5 to 70 wt-% of the total amount of inorganic oxide in the coating formulation, preferably for 5 to 50 wt-% of the total amount of inorganic oxide in the coating formulation, more preferably for 10 to 45 wt-% of the total amount of inorganic oxide in the coating formulation, and most preferably for 12 to 30 wt-% of the total amount of inorganic oxide in the coating formulation.

7. A method of preparing a coated substrate comprising the steps of

- providing a substrate;
- providing a coating formulation according to any one of the preceding embodiments;
- applying the coating formulation on the substrate;
- drying the coating formulation on the substrate; and
- converting the coating formulation on the substrate into a coated substrate.

8. A coated substrate obtainable by the method of the preceding embodiment.

9. The coated substrate according the preceding embodiment, wherein the substrate comprises a transparent solid sheet member with a base coating on a first side of the sheet member so the base coating forms at least a part of the first surface of the substrate, preferably the base coating is selected from the group of barrier coatings and anti-reflective coatings.

10. The coated substrate according to any one of the preceding embodiments, wherein a substrate-coating anti-soiling ratio, ASR

$$ASR = \frac{\left(T_{Substrate,0} - T_{Substrate,soil}\right) - \left(T_{Coating,0} - T_{Coating,soil}\right)}{\left(T_{Substrate,0} - T_{Substrate,soil}\right)}$$

is at least 50%, preferably the substrate-coating ASR is at least 75%, more preferably the substrate-coating ASR is at least 80%, and most preferably the substrate-coating ASR is at least 90%, where T is the is the average transmittance from 380-1100 nm measured by a Shimadzu UV2600 spectrophotometer, Substrate refer to substrate without coating, Coating refer to the substrate with double sided coating, 0 refer to before soil test.

11. The coated substrate according to any one of the preceding embodiments, wherein the coated substrate has a substrate-coating anti-reflective effect, ARE,

$$ARE = T_{Coated\ substrate,0} - T_{Substrate,0}$$

of at least 2%, preferably the ARE is at least 3%, more preferably the ARE is at least 4%, where T is the is the average transmittance in the wavelength range from 380-1100 nm measured by a Shimadzu UV2600 spectrophotometer, Substrate refer to substrate without coating, Coated substrate refer to the substrate with double sided coating.

12. The coated substrate according to any one of the preceding embodiments, wherein the coated substrate has an Antisoiling gain, ASG,

$$ASG = 1 - \frac{\left(T_{coated\ substrate\ with\ Al,0} - T_{coated\ substrate\ with\ Al,soil}\right)}{\left(T_{coated\ substrate\ without\ Al,0} - T_{coated\ substrate\ without\ Al,soil}\right)}$$

of at least 50%, preferably the ASG is at least 75%, where T is the is the average transmittance from 380-1100 nm measured by a Shimadzu UV2600 spectrophotometer, Coated Substrate with Al refer to a double side coated substrate with the coating with alumina and elongated particles and Coated Substrate without Al refer to a double side coated substrate with same coating except the alumina and dense inorganic oxide particles are excluded, 0 refer to before soil test and soil refer to after soil test.

13. A solar module comprising a coated substrate according to any one of the preceding embodiments,

14. The coated substrate according to any one of the preceding embodiments, wherein the mass ratio of inorganic oxide originating from the elongated dense inorganic oxide particles to total inorganic oxide of the coating is higher in the 20 nm of the coating closest to the outer surface of the coated substrate than the average mass ratio of the inorganic oxide originating from dense inorganic oxide particles to total inorganic oxide of the coating,
preferably the mass ratio of inorganic oxide originating from the dense inorganic oxide particles to total inorganic oxide of the coating is at least 50% higher in the 20 nm of the coating closest to the outer surface than the average mass ratio of the inorganic oxide originating from dense inorganic oxide particles to total inorganic oxide of the coating, more preferably the mass ratio of inorganic oxide originating from the dense inorganic oxide particles to total inorganic oxide of the coating is at least twice as high in the 20 nm of the coating closest to the outer surface than the average mass ratio of the inorganic oxide originating from dense inorganic oxide particles to total inorganic oxide of the coating.

15. A coating formulation comprising

    i. at least 2 wt-% based on inorganic oxide equivalents of elongated dense inorganic oxide particles with an aspect ratio of at least 2 and a smaller diameter in the range of 3 to 20 nm;

ii. a porogen capable of forming pores with a diameter in the range of 10 to 120 nm;

iii. an inorganic oxide binder; and

iv. a solvent, wherein the coating formulation optionally comprises between 0.1 to 30 wt-% aluminium oxide equivalents of aluminium containing compound , preferably the coating formulation optionally comprises between 0.5 to 30 wt-% aluminium oxide equivalents of aluminium containing compound, and wherein the porogen comprises an anionic polymer

16. The coating formulation according to any one of the preceding embodiments, wherein the porogen comprises anionic an anionic PMMA polymer.

17. The coated substrate according to any one of the preceding embodiments, wherein the porogen accounts for 10 to 75 wt-% of the total amount of inorganic oxide equivalents in the coating formulation, preferably the porogen accounts for 20 to 50 wt-% of the total amount of inorganic oxide equivalents in the coating formulation.

18. The coated substrate according to any one of the preceding embodiments, wherein the inorganic oxide binder comprises inorganic oxide nano particles with anaverage diameter in the range of 0.1 to 7 nm.

19. The coated substrate according to any one of the preceding embodiments, wherein the elongated dense inorganic oxide particles account for 5 to 70 wt-% of the total amount of inorganic oxide equivalents in the coating formulation, preferably for 5 to 50 wt-% of the total amount of inorganic oxide equivalents in the coating formulation, more preferably for 10 to 45 wt-% of the total amount of inorganic oxide equivalents in the coating formulation, and most preferably for 12 to 30 wt-% of the total amount of inorganic oxide equivalents in the coating formulation.

20. A method of preparing a coated substrate comprising the steps of

- providing a substrate having a first surface;
- providing a coating formulation according to any one of the preceding embodiments;
- applying the coating formulation on the first surface of the substrate;
- drying the applied coating formulation; and
- converting the substrate with dried coating formulation into a coated substrate comprising a coating layer on the first surface, for example by heating, such as by heating above 400 degrees Celsius.

21. A coated substrate obtainable by the method of the preceding embodiment, demonstrating improved anti-soiling properties.

22. A coated substrate comprising:

i. a substrate; and

ii. a porous anti-reflective coating layer arranged on at least a part of the substrate,

wherein the anti-reflective coating comprises

- pores with a diameter in the range of 10 to 120 nm, preferably 30 to 100 nm as measured using ellipsometry and / or electron microscopy; and
- elongated dense inorganic oxide particles with an aspect ratio of at least 2, and a smaller diameter in the range of 3 to 20 nm; and
- between 0.1 to 30 wt-% aluminium oxide equivalents of aluminium containing compound, preferably 0.5 to 25 wt-% aluminium oxide equivalents of aluminium containing compound.

23. The coated substrate according to any one of the preceding embodiments, wherein the substrate comprises a transparent solid sheet member, and a base coating layer interposed between the first surface and the coating layer on the first surface, preferably the base coating is selected from the group of barrier coatings and anti-reflective coatings.

24. The coated substrate according to any one of the preceding embodiments, wherein a substrate-coating anti-soiling ratio, ASR, with

$$ASR = \frac{(T_{Substrate,0} - T_{Substrate,soil}) - (T_{Coating,0} - T_{Coating,soil})}{(T_{Substrate,0} - T_{Substrate,soil})} \times 100\%$$

is at least 50%, preferably the substrate-coating ASR is at least 75%, more preferably the substrate-coating ASR is at least 80%, and most preferably the substrate-coating ASR is at least 90%, wherein T is the average transmittance in the wavelengths range from 380-1100 nm, Substrate refers to substrate without coating, Coating refers to the substrate with double sided coating, 0 refers to before soil test and soil refers to after soil test.

25. The coated substrate according to any one of the preceding embodiments, wherein the coated substrate has a substrate-coating anti-reflective effect, ARE, with

$$ARE = T_{Coated\ substrate,0} - T_{Substrate,0}$$

of at least 2%, preferably the ARE is at least 3%, more preferably the ARE is at least 4%, where T is the average transmittance in the wavelengths range from 380-1100 nm s, Substrate refers to substrate without coating, Coated substrate refers to the substrate with double sided coating and 0 refers to before soil test.

26. The coated substrate according to any one of the preceding embodiments, wherein the coated substrate has an Antisoiling gain, ASG, with

$$ASG = \left[1 - \frac{(T_{coated\ substrate\ with\ Al,0} - T_{coated\ substrate\ with\ Al,soil})}{(T_{coated\ substrate\ without\ Al,0} - T_{coated\ substrate\ without\ Al,soil})}\right] \times 100\%$$

of at least 50%, preferably the ASG is at least 75%, where T is the is the average transmittance in the wavelength range from 380-1100 nm, Coated Substrate with Al refers to a double side coated substrate with the coating with alumina and elongated particles and Coated Substrate without Al refers to a double side coated substrate with same coating where the alumina and dense inorganic oxide particles are excluded, 0 refers to before soil test and soil refers to after soil test.

27. The coated substrate according to any one of the preceding embodiments, wherein the mass ratio of inorganic oxide originating from the elongated dense inorganic oxide particles to total inorganic oxide of the coating is higher in a 20 nm thick top layer of the coating closest to the outer surface of the coated substrate than the average mass ratio of the inorganic oxide originating from dense inorganic oxide particles to total inorganic oxide of the coating, preferably the mass ratio of inorganic oxide originating from the dense inorganic oxide particles to total inorganic oxide of the coating is at least 50% higher in the top layer of the coating than the average mass ratio of the inorganic oxide originating from elongated dense inorganic oxide particles to total inorganic oxide of the coating, more preferably the mass ratio of inorganic oxide originating from the elongated dense inorganic oxide particles to total inorganic oxide of the coating is at least twice as high in the top layer the coating than the average mass ratio of the inorganic oxide originating from dense inorganic oxide particles to total inorganic oxide of the coating.

28. The coated substrate according to any one of the preceding embodiments,, wherein the substrate is a cover glass for a solar module.

29. A solar module comprising a coated substrate according to any one of the preceding embodiments.

30. Use of a coating formulation comprising elongated dense inorganic oxide particles with an aspect ratio of at least 2 and a smaller diameter in the range of 3 to 20 nm for improving anti-soiling properties of a substrate, wherein the coating formulation comprises a porogen, wherein the porogen comprises anionic an anionic PMMA polymer, wherein and the formulation optionally comprises between 0.1 to 30 wt-%, preferably between 0.5 to 30wt%, aluminium oxide equivalents of aluminium containing compound based on total ash rest after combustion at 600°C, 2 min in air.

MEASUREMENTS

### Method of optical measurement

The optical properties are measured in the wavelength region from 380-1100 nm using an Optosol Transpec VIS-NIR spectrophotometer equipped with an integrating sphere. The average transmittance and Max T% ($\lambda$ at Max) are determined. The results are listed below.

### Method of soiling measurement

*Soiling procedure:* The anti-soiling properties of the coatings are tested with a Taber Oscillating Abrasion Tester (model 6160) using commercially available Arizona test dust from quartz A4 coarse (size varying from 1 to 200 $\mu$m) as soiling medium, commercially available from KSL Staubtechnik GMBH. The 100 x 100 mm glass plate to be tested are first cleaned with deionized water and a soft cloth, rinsed with laboratory grade ethanol and left to dry overnight. The coated sample is then placed in the tray of the Taber Oscillating table so that the top surface of the glass plate was at the same height as the sample holder inside the tray. Next, 20 g of Arizona test dust is gently dispersed over the whole glass plate using a brush. The soiling procedure (300 cycles at a speed of 100 cycles per minute; one cycle is defined as a full revolution of the circular drive disk: one completed back-and-forth movement of the tray) is performed. The test sample is then removed from the tray and gently tapped to remove the excess of sand on its surface. The back side of the tested glass plate is gently wiped with a soft cloth to remove any dust adhering under the plate. A suitable relative humidity in the testing environment includes 36 %RH and a temperature of 21°C.

*Soiling evaluation:* The degree of soiling of the coatings is determined by relative loss in transmittance after soiling, measured with Optosol Transpec VIS-NIR spectrophotometer. To that end, transmittance spectra are recorded prior and post artificial soiling via the Taber Oscillating Abrasion Tester. Subsequently, the average of transmittance over 380-1100 nm spectra is established. Based on the resulting differences between the before and after values of the average transmittance over 380-1100 nm recorded in the spectra, conclusions regarding the level of soiling and hence the effectiveness of the anti-soiling coatings may be drawn.

### Method for determining inorganic oxide composition

Cured sample is scraped off substrate with razorblade. The scrapings is rinsed from the substrate with ethanol and collected. One drop of ethanol suspension is transferred to carbon grid and dried, where after the elemental composition is determined by STEM EDX on scrapings arranged on the edge of the carbon grid. At least components Si, O and Al are measured and amounts are determined by the software Esprit 1.9.

### Method for determining size of pores

Pore size of porogen pores, i.e. pores with a diameter in the range of 10 to 120 nm, is defined as the length of a line indicating the longest distance between walls of the pore on a cross section orthogonal to the surface of the substrate as measured by SEM. For irregular pore, the line indicating the longest distance may go outside pore. As is well known SEM stands for Scanning Electron Microscopy.

For binder pores with a pore size between 1 to 10 nm, ellipsometry is used to measure the pore size, using the method indicated herein. Since the method utilizes sorption of water in the pores, the measured size corresponds to the smallest diameter of the pore.

### Method for determining size of particles

The size of the binder particles and the size of the elongated dense inorganic particles are measured using CryoTEM. The average size is the number average size based on ten randomly selected particles.

### Ellipsometry

The volume fraction and pore size distribution of binder pores are determined by water sorption under variation of relative partial pressure of water. In a pore size regime ranging from 2 to 50 nm, the saturation pressure (and hence condensation/evaporation of water in the pores) is a function of the smallest dimension of the pore as described by the Kelvin equation. Condensation of water in the pores drastically changes the optical properties of the coating due to the difference in density between water and air, which optical properties are measured by ellipsometry.

Sample preparation depends on substrate type. For float glass, a scotch tape was applied on the backside of the glass to reduce backside reflections. For SM glass, measurement is done using focusing probes to reduce light scattering induced by the sample roughness. No scotch tape is applied at the backside in the case of SM glass.

The ellipsometer used is a Woollam M-2000 UI running CompleteEase (Woollam) version 5.20. Typically the refractive index herein is reported at an optical wavelength of 600 nm.

Data analysis/Method for modeling

The experimental data are analyzed by fitting to optical models built using CompleteEase. The bare, uncoated substrate is measured first and then fitted using a b-spline model. The coating layer is described by a Cauchy model, using the first two terms of the series development, A and B. For the evaluation of the model, the data measured at 35% rH may be used.

<u>EXAMPLES</u>

Example 1a: Preparation of anionic PMMA latex (porogen) dispersion

(Information used form the thesis entitled " Couches poreuses de silice structurées par des latex : structure, propriétés mécaniques et applications optiques" by François Guillemot 2010).

In a one liter, nitrogen filled, double-walled reactor at a temperature of 70C, equipped with a mecanical stirrer, a reflux column, 600g of de-ionised water (>16MOhm resistivity) and the surfactant (solid or liquid solution). In parallel, the methylmethacrylate (MMA, 99%, Aldrich) and the water diluted initiator are placed in flasks and equipped with rubber septa stoppers. The contents of the reactor as well as those of the flasks are evacuated under nitrogen via bubbling over a period of 15 min. The monomer et the polymerization initiator are introduced simultaneously in the reactor while stirring (250 rpm). The closed system reaction is completed under a nitrogen blanket. The reaction mixture becomes turbid after the addition of the monomer due to the monomer droplet formation. After a few minutes, the medium takes on a white color.

The progress of the reaction is then followed by dynamic light scattering to determine particle formation and size distribution. Furthermore, the dispersion solid content is followed by weight measurement to follow polymer conversion from the monomer. Once completed the reactor is emptied and store into polyethylene bottles. The shelf-life of the latex polymers synthesized synthesized varies between six months to 1 year. The anionic surfactant used in the polymerization is the Disponil FES 32 which has a chemical formula, $C_{12}H_{25}(OCH_2CH_2)_4SO_4^-$ Na+ with a critical micelle concentration of 0.26g/L (Cognis; 32%wt). Sodium dodecylsulfate (Aldrich) with a critical micelle concentration of 2g/L can also be used in stead of the Disponil. The polymerization initiator is ammonium persulfate which can eventually be coupled with a redox initiator of the type Na+,-OOS-CHOH-COO - ,Na+, commercialized by Brügemann Chemical under the trade name Bruggolit FF7.

Table B1 Latex polymerization parameters to form an average particle diameter size of 75nm
(Reaction time: 3h40)
Masse = mass; Total aqueux = Total aqueous
Table B2 Latex polymerization parameters to form an average particle diameter size of 60nm
(Reaction time: 3h)
Table B3 Latex polymerization parameters to form an average particle diameter size of 32nm
(Reaction time: 1h)

Tableau B.1 – Tableau d'engagement et paramètres du latex obtenu pour le latex d'environ **75 nm de diamètre** (durée de réaction : 3 heures 40 minutes)

|  | masse (g) | M (g/mol) | n (mol) | C (mol/L) | C (g/L) | Wt% |
|---|---|---|---|---|---|---|
| Eau | 600.1 | 18 | 3.33E+01 |  |  | 77.46 % |
| DISPONIL FES32 | 11.1 | 464 | 7.66E-03 | 1.00E-02 | 1.45E+01 | 0.46 % |
| APS | 0.806 | 228.2 | 3.53E-03 | 4.62E-03 | 1.05E+00 | 0.10 % |
| Total Aqueux | 612.006 |  |  |  |  | 79.00 % |
| MMA | 162.7 | 100.12 | 1.63E+00 | 2.13E+00 | 2.13E+02 | 21.00 % |
| Total Phase Mono. | 162.7 |  |  |  |  | 21.00 % |

| Dp (nm) | 73 |
|---|---|
| Ip | 0.051 |
| Ts | 22.00 |
| Tp | 21.44 |
| conversion | 1 |
| % couverture | 36.61 |

Tableau B.2 – Tableau d'engagement et paramètres du latex obtenu pour le latex d'environ **60 nm de diamètre** (durée de réaction : 3 heures)

|  | masse (g) | M (g/mol) | n (mol) | C (mol/L) | C (g/L) | Wt% |
|---|---|---|---|---|---|---|
| Eau | 600.4 | 18 | 3.34E+01 |  |  | 75.69 % |
| DISPONIL FES32 | 30.2 | 464 | 2.08E-02 | 2.66E-02 | 3.86E+01 | 1.22 % |
| APS | 2.404 | 228.2 | 1.05E-02 | 1.35E-02 | 3.07E+00 | 0.30 % |
| Total Aqueux | 633.004 |  |  |  |  | 79.80 % |
| MMA | 160.2 | 100.12 | 1.60E+00 | 2.04E+00 | 2.05E+02 | 20.20 % |
| Total Phase Mono. | 160.2 |  |  |  |  | 20.20 % |

| Dp (nm) | 58.6 |
|---|---|
| Ip | 0.054 |
| Ts | 21.88 |
| Tp | 20.36 |
| conversion | 1 |
| % couverture | 81.2 |

Tableau B.3 – Tableau d'engagement et paramètres du latex obtenu pour le latex d'environ **32 nm de diamètre** (durée de réaction : 1 heure)

|  | masse (g) | M (g/mol) | n (mol) | C (mol/L) | C (g/L) | Wt% |
|---|---|---|---|---|---|---|
| Eau | 599.1 | 18 | 3.33E+01 |  |  | 77.74 % |
| SDS | 21.4 | 288 | 7.43E-02 | 1.01E-01 | 2.91E+01 | 2.78 % |
| APS | 2.12 | 228.2 | 9.29E-03 | 1.26E-02 | 2.88E+00 | 0.28 % |
| Brüggolit | 1.502 |  |  |  | 2.04E+00 | 0.19 % |
| Total Aqueux | 624.122 |  |  |  |  | 80.99 % |
| MMA | 146.5 | 100.12 | 1.46E+00 | 1.99E+00 | 1.99E+02 | 19.01 % |
| Total Phase Mono. | 146.5 |  |  |  |  | 19.01 % |

| Dp (nm) | 32 |
|---|---|
| Ip | 0.06 |
| Ts | 22.14 |
| Tp | 18.89 |
| conversion | 0.99 |
| % couverture | 173 |

Example 1b: Preparation of core-shell particle solution

Core-shell particles are prepared by the method as disclosed in WO2009/030703 using the anionic PMMA latex dispersion from example 1a with the latex having an average particle size 60 nm (Table B2) of instead of the latex as described in WO2009/030703. The solution is further diluted with isopropanol to a concentration of 10.0 wt-% silica equivalents.

Example 2: Preparation of inorganic binder

Silica based inorganic binder was prepared from tetraethoxysilane was prepared by the same method as disclosed in WO 2011/157820 and further diluted with isopropanol to achieve a binder solution of about 2 wt-% silica equivalents and a particle size of 3-5 nm.

Example 3: Preparation of stock solutions

Al-Stock solution was prepared by dissolving $Al(NO_3)_3$.9H2O (Fluka, 06275 Lot SZBG0830V) into a mixture of isopropanol (Brenntag, batch l/103/3jul 15/13333, Ref 2427801) and 2-methoxypropanol (Sigma Aldrich, Lot K49958738820) to a solid content of 5%. Thereafter the solution was further diluted with isopropanol to 2 wt-% alumina equivalents.

Stock solution of elongated IPA-ST-UP particles was prepared by diluting IPA-ST-UP (Nissan Chemical, Lot 111002) with isopropanol to a concentration of 2 wt-% of oxide equivalents. This stock solution was used to prepare the samples in Table 1.

Example 4: Preparation of coating formulations

All formulations were made in a 500 ml semi-transparent HDPE bottle with lid. Amounts of each component are indicated in Table 1. Core-shell solution weighted and 2-propanol was added and the bottle shaken. To this mixture, the inorganic binder was added and the bottle shaken. Subsequently the diluted Al-stock solution was added, and finally the stock solution of elongated particles was added. Amounts of each component are indicated in Table 6.

Example 5: Coating of samples

Coatings are prepared with coating formulations that were used were maximum 48 h old. All samples were soiled within 48 h after preparation of the coating. Formulations were filled into a rectangular shaped container, with an inner size of 2.5*11*11 cm filled with approximately 200 g of coating formulation.

Glass used was 3.2 mm Pilkington Optiwhite S float glass cut into 10*10 cm plates. Plates were washed and dried prior to coating application. Dipping conditions were: 18.5-21.4°C; relative humidity <20% rH; dipping speed was varied between 4 and 5 mm/s as indicated in Table 1. The dipping speed was set such that an optical thickness of about 600 nm was obtained.

Table 1

| Sample | Core-shell solution (g) | Isopropanol (g) | Silica based binder (g) | Elongated particles solution (g) | Al-stock solution (g) | Dip-speed (mm/s) |
|--------|-------------------------|-----------------|-------------------------|----------------------------------|------------------------|------------------|
| 1 | 7.9 | 72.1 | 80.2 | 40.1 | 0 | 5.5 |
| 2 | 7.9 | 72.1 | 80.6 | 40.0 | 2.2 | 5.5 |
| 3 | 7.9 | 71.7 | 80.1 | 39.9 | 4.0 | 5.5 |
| 4 | 7.9 | 72.0 | 80.1 | 40.0 | 8.1 | 5.5 |
| 5 | 7.9 | 72.2 | 80.7 | 40.1 | 16.0 | 5.5 |
| 6 | 8.1 | 72.0 | 80.1 | 40.3 | 31.9 | 5.5 |
| 7 | 7.9 | 71.8 | 80.3 | 40.3 | 64.0 | 4.2 |
| 8 | 8.0 | 72.1 | 80.1 | 0.0 | 0.0 | 5.5 |
| 9 | 8.0 | 72.0 | 80.1 | 40.0 | 0.5 | 5.5 |

(continued)

| Sample | Core-shell solution (g) | Isopropanol (g) | Silica based binder (g) | Elongated particles solution (g) | Al-stock solution (g) | Dip-speed (mm/s) |
|---|---|---|---|---|---|---|
| 10 | 8.0 | 72.0 | 80.1 | 40.0 | 1.0 | 5.5 |
| 11 | 8.0 | 72.0 | 80.1 | 40.0 | 1.9 | 5.5 |
| 12 | 8.0 | 72.0 | 80.1 | 40.0 | 5.6 | 5.5 |
| 13 | 65 | 52.4 | 6.7 | - | - | 2.5 |
| 14 | 65 | 52.4 | 6.7 | - | 3.4 | 2.5 |
| 15 | 65 | 52.4 | 6.7 | 15 | 3.4 | 2.5 |

Example 6: Conversion of applied coating formulation into a functional coating

The coated samples listed in table 1 are dried at least 15 minutes at room temperature and thereafter cured by heating in an oven at 650°C for 3.5 minutes. This treatment is like the thermal conversion realized during the tempering process typically used for cover glass for PV solar modules. The results of the optical measurements on the coated substrate will demonstrate that the coatings show improved anti-soiling properties.

**Claims**

1. A coating formulation comprising

   i. at least 2 wt-% based on oxide equivalents of inorganics of elongated inorganic dense oxide particles with an aspect ratio of at least 2 and an average smaller diameter in the range of 3 to 20 nm as measured by TEM, and
   ii. a porogen capable of forming pores with a diameter in the range of 10 to 120 nm,
   iii. an inorganic oxide binder, and
   iv. a solvent,

   wherein the coating formulation optionally comprises between 0.5 to 30 wt-% aluminium oxide equivalents of aluminium containing compound based on total ash rest after combustion at 600°C, 2 min in air, preferably the coating formulation comprises between 1.0 to 25 wt-% aluminium oxide equivalents of aluminium containing compound based on total ash rest after combustion at 600°C, and wherein the porogen comprises an anionic polymer.

2. The coating formulation according to the preceding claim, wherein the porogen comprises anionic an anionic PMMA polymer latex and/or polyelectrolyte..

3. The coating formulation according to any one of the preceding claims, wherein the porogen comprises core-shell nanoparticles, wherein the core comprises an anionic PMMA polymer latex and/or polyelectrolyte and the shell comprises an inorganic oxide.

4. The coating formulation according to any one of the preceding claims, wherein the inorganic binder comprises inorganic oxide nano particles with a number average diameter in the range of 0.1 to 7 nm.

5. The coating formulation according to any one of the preceding claims, wherein the elongated dense inorganic oxide particles account for 5 to 70 wt-% of the total amount of inorganic oxide in the coating formulation, preferably for 5 to 50 wt-% of the total amount of inorganic oxide in the coating formulation, more preferably for 10 to 45 wt-% of the total amount of inorganic oxide in the coating formulation, and most preferably for 12 to 30 wt-% of the total amount of inorganic oxide in the coating formulation.

6. A method of preparing a coated substrate comprising the steps of

   - providing a substrate;
   - providing a coating formulation according to any one of the preceding claims;

- applying the coating formulation on the substrate;
- drying the coating formulation on the substrate; and
- converting the coating formulation on the substrate into a coated substrate.

7. A coated substrate obtainable by the method of the preceding claim.

8. A coated substrate comprising:

   i. a substrate; and
   ii. a porous anti-reflective coating layer arranged on at least a part of the substrate,

   wherein the anti-reflective coating comprises

   - pores with a diameter in the range of 1 to 80 nm; and
   - elongated dense inorganic oxide particles with an aspect ratio of at least 2, and an average smaller diameter in the range of 3 to 20 nm; and
   - optionally between 0.1 to 30 wt-% aluminium oxide equivalents of aluminium containing compound, preferably 0.5 to 25 wt-% aluminium oxide equivalents of aluminium containing compound.

9. A solar module comprising a coated substrate according to any one of the preceding claims.

Figure 1

Fig. 1a

Fig. 1b

Fig. 1c

Fig. 1d

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | WO 2018/192908 A2 (DSM IP ASSETS BV [NL]) 25 October 2018 (2018-10-25) * page 5, lines 1-16; claims 1-16; examples 1-9; tables 1-8 * * page 8, lines 1-5 * * page 10, lines 31-32 * | 1-9 | INV. C09D1/00 C03C17/00 C09D5/00 C09D5/16 G02B1/10 G02B1/11 G02B1/111 H01L31/0216 C09D7/40 |
| X | EP 2 808 368 A1 (ASAHI KASEI E MATERIALS CORP [JP]) 3 December 2014 (2014-12-03) * paragraphs [0018], [0031], [0060], [0092], [0105], [0106], [0129], [0178]; claims 1-18; examples 1,2 * | 1-9 | |
| Y | US 2014/178657 A1 (JEWHURST SCOTT [US] ET AL) 26 June 2014 (2014-06-26) * paragraphs [0025], [0076], [0081] - [0085]; examples 1, 3-5, 7 * | 1-9 | |
| Y | XIANPENG ZHANG ET AL: "Multifunctional Antireflection Coatings Based on Novel Hollow Silica-Silica Nanocomposites", ACS APPLIED MATERIALS & INTERFACES, vol. 6, no. 3, 12 February 2014 (2014-02-12), pages 1415-1423, XP055570125, US ISSN: 1944-8244, DOI: 10.1021/am405258d * Paragraph "Material and Methods" on pages 1417-1418; figures 2-8; table 1 * | 1-9 | TECHNICAL FIELDS SEARCHED (IPC) C09D C03C C08K G02B H01L |
| X A | US 2013/163087 A1 (LECOLLEY FRANCOIS [BE] ET AL) 27 June 2013 (2013-06-27) * paragraphs [0028] - [0032], [0045], [0046], [0059] - [0067]; claims 1-15 * | 8,9 1-7 | |

The present search report has been drawn up for all claims

| Place of search | Date of completion of the search | Examiner |
|---|---|---|
| Munich | 19 March 2019 | Schmitt, Johannes |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 20 0798

19-03-2019

| Patent document cited in search report | | Publication date | Patent family member(s) | | | Publication date |
|---|---|---|---|---|---|---|
| WO 2018192908 | A2 | 25-10-2018 | TW | 201843124 | A | 16-12-2018 |
| | | | WO | 2018192908 | A2 | 25-10-2018 |
| | | | WO | 2018192910 | A2 | 25-10-2018 |
| EP 2808368 | A1 | 03-12-2014 | CN | 104066805 | A | 24-09-2014 |
| | | | EP | 2808368 | A1 | 03-12-2014 |
| | | | JP | 6081929 | B2 | 15-02-2017 |
| | | | JP | WO2013111783 | A1 | 11-05-2015 |
| | | | KR | 20140102283 | A | 21-08-2014 |
| | | | TW | 201348357 | A | 01-12-2013 |
| | | | US | 2015059846 | A1 | 05-03-2015 |
| | | | WO | 2013111783 | A1 | 01-08-2013 |
| US 2014178657 | A1 | 26-06-2014 | NONE | | | |
| US 2013163087 | A1 | 27-06-2013 | AU | 2011298373 | A1 | 11-04-2013 |
| | | | BR | 112013005129 | A2 | 16-05-2017 |
| | | | CA | 2810173 | A1 | 08-03-2012 |
| | | | CN | 103813993 | A | 21-05-2014 |
| | | | EA | 201390299 | A1 | 30-08-2013 |
| | | | EP | 2611749 | A2 | 10-07-2013 |
| | | | JP | 2013537873 | A | 07-10-2013 |
| | | | US | 2013163087 | A1 | 27-06-2013 |
| | | | WO | 2012028626 | A2 | 08-03-2012 |

EPO FORM P0459

For more details about this annex : see Official Journal of the European Patent Office, No. 12/82

**EP 3 640 303 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007093341 A
- WO 2009106456 A
- WO 2009030703 A
- WO 2011157820 A

**Non-patent literature cited in the description**

- **FUJI, M. ; TAKAI, C. ; RIVERA VIRTUDAZO, R. V.** *Adv. Powder Tech.,* 2014, vol. 25, 91-100
- **ZHANG, X. et al.** *App. Mater. Interfaces,* 2014, vol. 6, 1415-1423
- **FRANÇOIS GUILLEMOT.** *Couches poreuses de silice structurées par des latex : structure, propriétés mécaniques et applications optiques,* 2010